# EUROPEAN PATENT APPLICATION

(11) **EP 4 557 376 A1**
(43) Date of publication of application: **21.05.2025**
(21) Application number: 24181005.0
(22) Date of filing: 10.06.2024
(51) Int. Cl.: H01L 29/737, H01L 29/08, H01L 29/06

(54) **VERTICAL HETEROJUNCTION BIPOLAR TRANSISTOR**

(30) Priority: 17.11.2023 US 202318512859
(71) Applicant: GlobalFoundries U.S. Inc., Malta, NY 12020 (US)
(72) Inventor: HOLT, Judson R., Malta, NY, 12020 (US); KENNEY, Crystal R., Malta, NY, 12020 (US); JAIN, Vibhor, Essex Junction, VT, 05452 (US); PEKARIK, John J., Essex Junction, VT, 05452 (US); NAFARI, Mona, Malta, NY, 12020 (US); JOHNSON, Jeffrey B., Malta, NY, 12020 (US)
(74) Representative: Lambacher, Michael

(57) **Abstract**

The present disclosure relates to semiconductor structures and, more particularly, to vertical heterojunction bipolar transistors and methods of manufacture. The structure includes: a sub-collector region; a collector region above the sub-collector region; an intrinsic base above the collector region; an emitter above the intrinsic base region; and an extrinsic base on the intrinsic base and adjacent to the emitter, wherein the collector region includes an undercut profile comprising lower inwardly tapered sidewalls and upper inwardly tapered sidewalls which extend to a narrow section between the sub-collector region and the base region.

## Description

### BACKGROUND

This invention was made with government support under Contract # HR0011-203-0002 awarded by DARPA-T-MUSIC. The government has certain rights in the invention.

The present disclosure relates to semiconductor structures and, more particularly, to vertical heterojunction bipolar transistors and methods of manufacture.

A heterojunction bipolar transistor is a type of bipolar junction transistor which uses differing semiconductor materials for the emitter and base regions, creating a heterojunction. The heterojunction bipolar transistor can handle signals of very high frequencies, up to several hundred GHz. The heterojunction bipolar transistor may be used in modern ultrafast circuits including radio frequency (RF) systems, and in applications requiring a high power efficiency, such as RF power amplifiers in cellular telephones.

### SUMMARY

In an aspect of the disclosure, a structure comprises: a sub-collector region; a collector region above the sub-collector region; an intrinsic base above the collector region; an emitter above the intrinsic base region; and an extrinsic base on the intrinsic base and adjacent to the emitter, wherein the collector region includes an undercut profile comprising lower inwardly tapered sidewalls and upper inwardly tapered sidewalls which extend to a narrow section between the sub-collector region and the base region. Additional features of the structure are set forth in dependent claims 2 to 10.

In an aspect of the disclosure, a structure comprises: a sub-collector region comprising a first semiconductor material; an intrinsic base; an emitter; an extrinsic base on the intrinsic base and adjacent to the emitter; and a collector comprising an undercut profile comprising lower inwardly tapered sidewalls and upper inwardly tapered sidewalls which extending to a narrow section between the sub-collector region and the intrinsic base.
Additional features of the structure are set forth in dependent claims 12 to 14.

In an aspect of the disclosure, a method comprises: forming a sub-collector region; forming a collector above the sub-collector region; forming an intrinsic base above the collector region; forming an emitter above the intrinsic base region; forming an extrinsic base on the intrinsic base and adjacent to the emitter; and forming an undercut in the collector region, the undercut comprising lower inwardly tapered sidewalls and upper inwardly tapered sidewalls which extending to a narrow section between the sub-collector region and the extrinsic base.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure and respective fabrication processes in accordance with additional aspects of the present disclosure.
FIG. 3 shows a structure and respective fabrication processes in accordance with further aspects of the present disclosure.
FIGS. 4A-4F show various collector profiles in accordance with aspects of the present disclosure.

### DETAILED DESCRIPTION

The present disclosure relates to semiconductor structures and, more particularly, to vertical heterojunction bipolar transistors and methods of manufacture. More specifically, the present disclosure is directed to a vertical heterojunction bipolar transistor with a sidewall undercut (e.g., undercut profile) and methods of manufacture. Advantageously, the present disclosure provides the ability to control and modify a recess structure to achieve a high performance device.

In embodiments, the high performance device described herein may be a vertical heterojunction bipolar transistor with different collector profiles. The vertical heterojunction bipolar transistor may include, for example, an N+ Si/SiGe sub-collector, an n-type Si collector, a p-SiGe base and an n+ Si emitter; although other materials are contemplated herein. For example, although the high performance device is described with respect to an NPN transistor structure, it should be understood by those of skill in the art that the high performance device can equally be a PNP transistor structure by reversing the doping scheme. An undercut profile may be provided in the collector between the base and sub-collector. A lateral width of the collector is less than sub-collector and base.

The vertical heterojunction bipolar transistors of the present disclosure can be manufactured in a number of ways using a number of different tools. In general, though, the methodologies and tools are used to form structures with dimensions in the micrometer and nanometer scale. The methodologies, i.e., technologies, employed to manufacture the vertical heterojunction bipolar transistor of the present disclosure have been adopted from integrated circuit (IC) technology. For example, the structures are built on wafers and are realized in films of material patterned by photolithographic processes on the top of a wafer. In particular, the fabrication of the vertical heterojunction bipolar transistors uses three basic building blocks: (i) deposition or growth of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

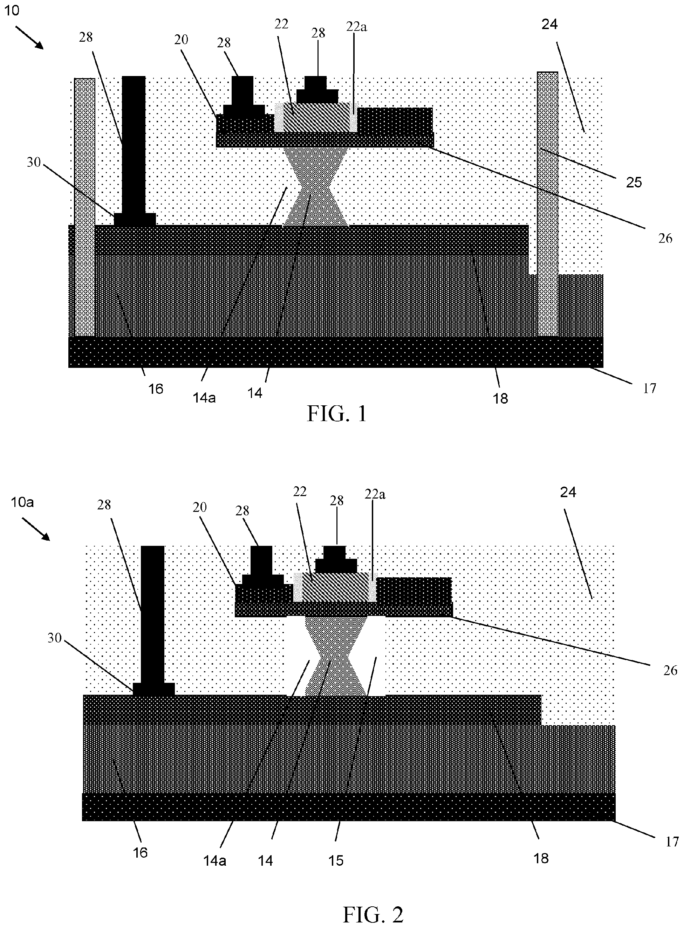

FIG. 1 shows a structure and respective fabrication processes in accordance with aspects of the present disclosure. In particular, the structure 10 of FIG. 1 shows a collector 14 with an undercut region (e.g., profile) 14a. The collector 14 may be provided between a sub-collector 16, 18, an extrinsic base 20 and an emitter 22. The undercut region 14a may be filled with interlevel dielectric material 24 formed by conventional deposition processes, e.g., chemical vapor deposition (CVD). An optional deep trench isolation structure 25 may be provided to isolate the device.

More specifically, in the structure 10 of FIG. 1, the sub-collector 16, 18 may comprise preferably Si material and, more preferably N+ doped Si material. For example, the sub-collector 16 may be doped with phosphorus (e.g., SiP). The sub-collector 16 may also be single crystalline semiconductor material with a suitable crystallographic orientation (e.g., a (100), (110), (111), or (001) crystallographic orientation). As should be understood by those of skill in the art, the sub-collector 16 may be formed on a p-type substrate 17 as is known in the art such that no further explanation is required for a complete understanding of the present invention.

The semiconductor material 18 may be another type of semiconductor material, e.g., SiGe. In preferred embodiments, the semiconductor material 18 may be N+ SiGe material epitaxially grown on the sub-collector 16. For example, the SiGe material may be in-situ doped with phosphorous (SiGeP), as an example. Alternatively, the SiGe material may be implanted or may be doped by out-diffusion from the surrounding regions. In embodiments, the sub-collector 16 may comprise both N-type Si as well as N-type SiGe. That is, it is possible that the entire sub-collector region could be SiGe, or it could be just a thin layer of SiGe with N-type Si above and below. It should also be recognized as described herein that the at least one layer of N-type SiGe, which may be in the collector or sub-collector region, will serve as an etch stop for the undercut recess, e.g., undercut profile 14a as described herein.

The collector 14 may be a same material as the semiconductor substrate 16. For example, the collector 14 may be n-doped Si material. In embodiments, the lateral width of the collector 14 is less than a length (or width depending on the perspective view) of the sub-collector material 18 and the intrinsic base 26 or the extrinsic base 20, and the undercut profile 14a is between the sub-collector 18 and the intrinsic base 26 or the extrinsic base 20.

The undercut profile (e.g., region) 14a of the collector 14 may comprise an narrowed or undercut region, e.g., narrowed profile portion, which is filled with and surrounded by interlevel dielectric material 24. The interlevel dielectric material 24 may also be over the semiconductor substrate 16, 18 and surrounding the collector 14, intrinsic base 26, extrinsic base 20 and emitter 22. In embodiments, the interlevel dielectric material 24 may be oxide, nitride or combinations thereof.

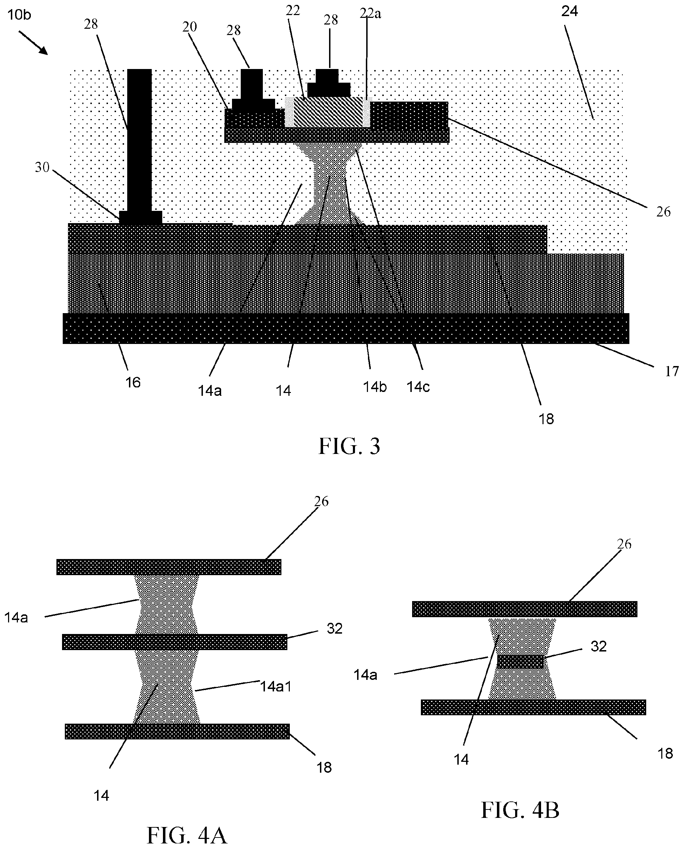

In this embodiment, the undercut region 14a may comprise a narrow middle portion and wider upper and lower portions. In more specific embodiments, the undercut region 14a may include an inwardly tapered sidewall profile from the top to middle portion and from the bottom to the middle portion, resulting in a middle portion having a narrowest cross section along a vertical axis; although other configurations are contemplated herein as further described with respect to the different embodiments shown in FIGS. 4A-4F. The undercut region 14a may be formed by a wet or dry etch with a selective chemistry to etch the material of the collector 14. It should be understood by those of skill in the art that the term "taper" can apply to both sharply faceted and rounded recess shapes or combinations thereof.

Still referring to FIG. 1, the intrinsic base 26 may for formed over the collector 14. In embodiments, the intrinsic base 26 may be a p-doped semiconductor material. In more specific embodiments, the intrinsic base 26 may be SiGe. For example, the intrinsic base 26 may be epitaxially grown from the collector 14 with an in-situ p-type dopant, followed by a conventional patterning process, e.g., lithography and etching (reactive ion etching (RIE) processes). In preferred embodiments, the p-type dopant comprises Boron resulting in SiGeB. The intrinsic base 26 should be different material than the collector 14 so as to be able to provide the undercut through a selective etching process.

The extrinsic base 20 may be formed over the intrinsic base 26, surrounding or on sides of the emitter 22. The emitter 22 may be formed on the intrinsic base 26 and may be isolated from the extrinsic base 20 by sidewall spacers 22a. The sidewall spacers 22a may be a nitride and/or oxide material formed by a conventional deposition process, e.g., CVD, followed by an anisotropic etching process. The emitter 22 may comprise an n-doped semiconductor material. For example, the dopant may be phosphorous (resulting in SiP) or arsenic (resulting in SiAs). The emitter 22 may be formed by conventional epitaxial growth processes with an in-situ doping process as is known in the art. In embodiments, the emitter 22 may be formed after the extrinsic base 20. For example, the material for the emitter 22 may be deposited in a trench etched through the extrinsic base 20 as is known in the art.

Following the formation of the emitter 22, the extrinsic base 20 may be formed adjacent sides of the sidewall spacers 22a. In embodiments, the extrinsic base 20 may be formed by conventional epitaxial growth processes with an in-situ doping process as is known in the art. The extrinsic base 20 may be epitaxially grown on the collector 14, with a p-type dopant. In preferred embodiments, the p-type dopant comprises Boron resulting in SiB or SiGeB, as examples. Other examples of suitable semiconductor materials used for the collector 14, sub-collector 16, 18, emitter 22 and bases 20, 26 may be SiGeC, SiC, GE alloys, GaAs, InAs, InP, and other III/V or II/VI compound semiconductors, noting a selectivity should still be present with respect to the collector 14.

FIG. 1 further shows contacts 28, e.g., wiring structures or interconnect structures, and silicide contacts 30. The contacts 28 and silicide contacts 30 may be directly in contact with the sub-collector 18, the emitter 22 and the extrinsic base 20. In embodiments, the contacts 28 may be formed through the interlevel dielectric material 24 by conventional lithography, etching and deposition methods known to those of skill in the art.

For example, a resist formed over the interlevel dielectric material 24 is exposed to energy (light) and developed utilizing a conventional resist developer to form a pattern (opening). An etching process with a selective chemistry, e.g., reactive ion etching (RIE), will be used to transfer the pattern from the photoresist layer to the interlevel dielectric material 24 to form one or more trenches in the interlevel dielectric material 24 through the openings of the resist. Following the resist removal by a conventional oxygen ashing process or other known stripants, conductive material, e.g., W, Al, Cu with a TiN or TaN liner, for example, can be deposited by any conventional deposition processes, e.g., CVD processes. Any residual material on the surface of the insulator interlevel dielectric material 24 can be removed by conventional chemical mechanical polishing (CMP) processes.

Also, as should be understood by those of skill in the art, the silicide process begins with deposition of a thin transition metal layer, e.g., nickel, cobalt or titanium, over fully formed and patterned semiconductor devices (e.g., sub-collector 16, the emitter 22 and the extrinsic base 20). After deposition of the material, the structure is heated allowing the transition metal to react with exposed silicon (or other semiconductor material as described herein) in the active regions of the semiconductor device (e.g., sub-collector 16, the emitter 22 and the extrinsic base 20) forming a low-resistance transition metal silicide. Following the reaction, any remaining transition metal is removed by chemical etching, leaving silicide contacts 30 in the active regions of the device.

FIG. 2 shows another structure 10a in accordance with additional aspects of the present disclosure. In the structure 10a of FIG. 2, the collector 14 includes the undercut region 14a surrounded by an airgap 15 formed in the interlevel dielectric material 24. The airgap 15 preferably extends to the sidewalls of the collector 14. In embodiments, the airgap 15 may be formed by a conventional pinch-off process, which is formed during the deposition of the interlevel dielectric material 24 as is known in the art. The remaining features of the structure 10a are similar to the structure 10 of FIG. 1 such that no further explanation is required for a complete understanding of the present disclosure.

FIG. 3 shows another structure 10b in accordance with additional aspects of the present disclosure. In the structure 10b of FIG. 3, the undercut region 14a includes a straight portion 14b and a tapered portion 14c. The tapered portion 14c comprises an inwardly tapered profile from the top to the straight section 14b (at an approximate mid portion) and from the bottom to the to the straight section 14b (at an approximate mid portion). It should be understood by one skilled in the art that the recessed profile may include embodiments that are rounded and/or asymmetric. In this and other embodiments described herein, the collector 14 and undercut region 14a may be surrounded by the interlevel dielectric material 24 or an airgap formed in the interlevel dielectric material 24. The remaining features of the structure 10b are similar to the structure 10 of FIG. 1 such that no further explanation is required for a complete understanding of the present disclosure.

FIGS. 4A-4F show various profiles of collectors in accordance with aspects of the present disclosure. For example, FIG. 4A shows a collector 14 with two recessed portions 14a, 14a1 separated along the vertical axis by a layer of semiconductor material 32. In embodiments, the layer of semiconductor material 32 will extend through a wider portion of the collector 14. Also, in embodiments, each of the recessed portions 14a, 14a1 include inwardly tapered sidewalls as already described herein.

The layer of semiconductor material 32, as with each of the undercut profiles described with respect to FIGS. 4A-4F, may be semiconductor material that etches selectively with respect to the semiconductor material of the collector 14. In embodiments, the layer of semiconductor material 32 may be the same material as the semiconductor material used for the sub-collector 18 and the extrinsic base 28. For example, the layer of semiconductor material 32 may be SiGe; whereas the collector 14 may be Si. Also, it should be understood by those of skill in the art that by including one or more SiGe layers with a lower or higher percentage Ge material, by varying the spacing of the layer 32, percentage of Ge, or thickness, the undercut profile can be precisely tuned to achieve any desired shape. For example, in the embodiment of FIG. 4A, a higher percentage of Ge can be used to provide the desired profile.

FIG. 4B shows a collector 14 with a recessed portion 14a comprising inwardly tapered sidewalls, as noted in the structures 10, 10a, 10b. In this embodiment, though, a layer of semiconductor material 32 may extend through the narrow region of the collector 14, approximately at the center along the vertical axis. Also, as should now be understood, the undercut profile 14a shown in the embodiment of FIG. 4B can be precisely tuned by providing a lower percentage of Ge in order to obtain the desired shape. In this way, to obtain a wider region of the undercut profile would use a higher percentage of Ge, compared to a lower percentage of Ge for a narrower section of the undercut profile.

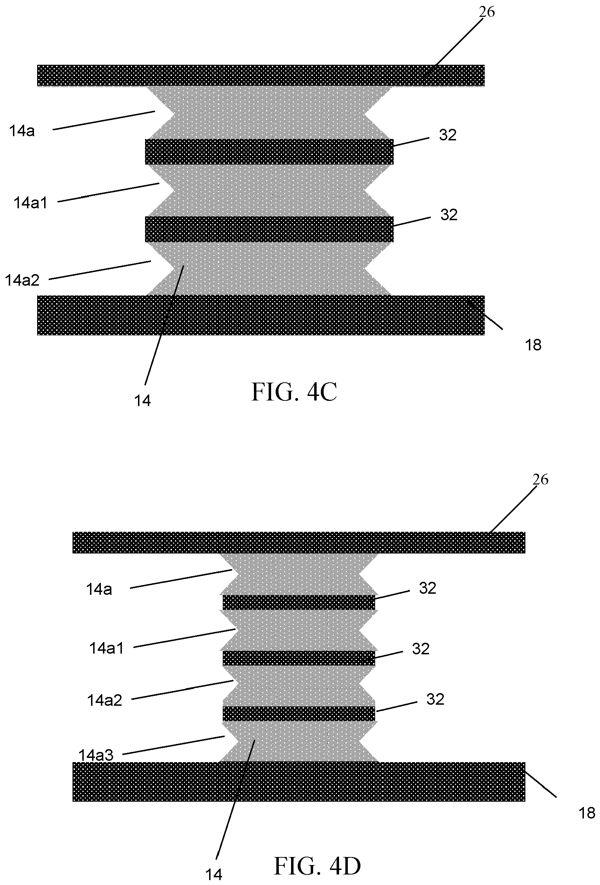

FIGS. 4C and 4D show collectors 14 with multiple recessed portions separated along the vertical axis by one or more layers of semiconductor material 32. For example, in FIG. 4C, the collector 14 includes three recessed portions 14a, 14a1, 14a2, each of which are separated from one another in the vertical axis by a layer of semiconductor material 32. In FIG. 4D, the collector 14 includes four recessed portions 14a, 14a1, 14a2, 14a3, each of which are separated from one another in the vertical axis by a layer of semiconductor material 32. It should be understood by those of skill in the art that more recessed portions (and respective layers of semiconductor material 32), or layers of different thicknesses, spacing, and/or composition are also contemplated by the present disclosure.

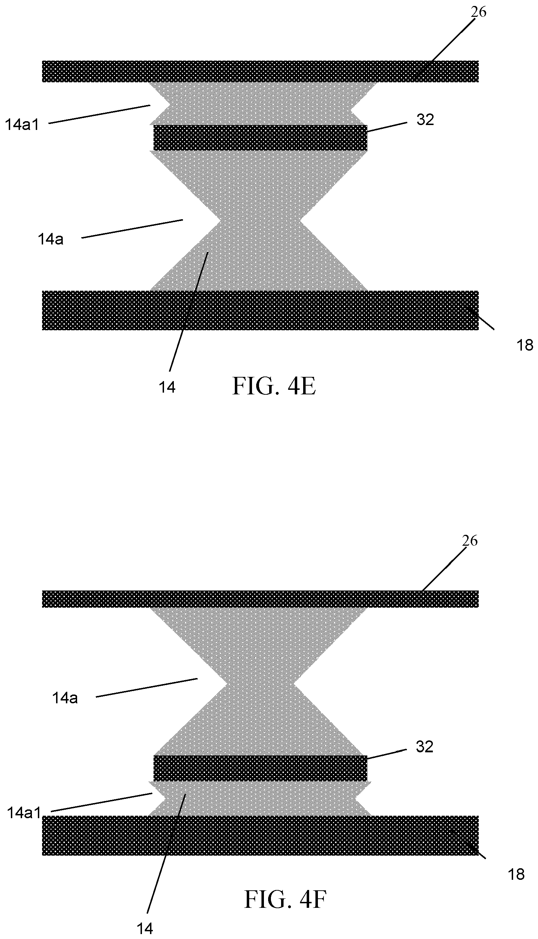

FIGS. 4E and 4F show collectors 14 with multiple recessed portions asymmetrically positioned in the vertical axis, separated in the vertical direction by a layer of semiconductor material 32. For example, in both FIGS. 4E and 4F, the undercut region 14a is smaller than the undercut region 14a1. In FIG. 4E, the undercut region 14a1 is closer to the extrinsic base 26 and, in FIG. 4F, the undercut region 14a1 is closer to the sub-collector 18. The spacings and positions of the undercut regions 14a, 14a1 along the vertical axis can be tuned by adjusting the location of the layer of semiconductor material 32 within the collector 14.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a sub-collector region;
a collector region above the sub-collector region;
an intrinsic base above the collector region;
an emitter above the intrinsic base region; and
an extrinsic base on the intrinsic base and adjacent to the emitter,
wherein the collector region includes an undercut profile comprising lower inwardly tapered sidewalls and upper inwardly tapered sidewalls which extend to a narrow section between the sub-collector region and the base region.

2. The structure of claim 1, wherein the sub-collector region and the intrinsic base comprise a semiconductor material which is different than a semiconductor material of the collector, and, optionally, wherein the semiconductor material of the sub-collector comprises at least n-type SiGe, the intrinsic base comprises p-type SiGe and the collector comprises n-type Si.

3. The structure of claim 1 or claim 2, wherein the undercut profile comprises lower inwardly tapered sidewalls and upper inwardly tapered sidewalls which extending to a narrow section between the sub-collector region and the extrinsic base.

4. The structure of one of claims 1 to 3, wherein the narrow section comprises a straight sidewall profile.

5. The structure of one of claims 1 to 4, further comprising a layer of semiconductor material extending through the narrow section of the collector, which is different than a semiconductor material of the collector region.

6. The structure of one of claims 1 to 4, wherein the undercut profile comprises two recessed portions separated along a vertical axis by a layer of semiconductor material that is different than a semiconductor material of the collector, and, optionally, wherein the layer of semiconductor material is a same semiconductor material as the sub-collector.

7. The structure of claim 6, wherein the layer of semiconductor material extends through a wider portion of the undercut profile of the collector.

8. The structure of one of claims 1 to 4, wherein the undercut profile comprises multiple recessed portions.

9. The structure of claim 8, wherein each of the multiple recessed portions are separated along a vertical axis by a semiconductor material that is different than a semiconductor material of the collector, and/or wherein each of the multiple recessed portions are asymmetrically positioned along the vertical axis.

10. The structure of one of claims 1 to 9, further comprising an airgap extending to the upper and lower inwardly tapered sidewalls, and further surrounding the undercut profile.

11. A structure comprising:
a sub-collector region comprising a first semiconductor material;
an intrinsic base;
an emitter;
an extrinsic base on the intrinsic base and adjacent to the emitter; and
a collector comprising an undercut profile comprising lower inwardly tapered sidewalls and upper inwardly tapered sidewalls which extending to a narrow section between the sub-collector region and the intrinsic base.

12. The structure of claim 11, wherein the first semiconductor material comprises SiGe, the intrinsic base comprise p-type doped SiGe and the sub-collector region comprises n-type doped SiGe and the semiconductor material of the collector comprises Si, and/or wherein the sub-collector region comprises both Si material and SiGe material, with the SiGe material being an etch stop layer.

13. The structure of claim 11 or claim 12, wherein the narrow section comprises a straight sidewall profile, and/or wherein the structure further comprises an airgap surrounding the undercut profile.

14. The structure of one of claims 11 to 13, wherein the undercut profile comprises multiple recessed portions each of which are separated along a vertical axis by a layer of semiconductor material that is different than a semiconductor material of the collector.

15. A method comprising:
forming a sub-collector region;
forming a collector above the sub-collector region;
forming an intrinsic base above the collector region;
forming an emitter above the intrinsic base region;
forming an extrinsic base on the intrinsic base and adjacent to the emitter; and
forming an undercut in the collector region, the undercut comprising lower inwardly tapered sidewalls and upper inwardly tapered sidewalls which extending to a narrow section between the sub-collector region and the extrinsic base.
